(19) Europäisches Patentamt

European Patent Office

Office européen des brevets

(11) **EP 4 776 066 A1**

(12) **EUROPEAN PATENT APPLICATION**

(43) Date of publication:
**15.07.2026 Bulletin 2026/29**

(21) Application number: **25150638.2**

(22) Date of filing: **08.01.2025**

(51) International Patent Classification (IPC):
*G03F 7/00* *(2006.01)*

(52) Cooperative Patent Classification (CPC):
**G03F 7/707; G03F 7/70741**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventor: **VAN DE KERKHOF, Marcus, Adrianus**
**5500 AH Veldhoven (NL)**

(74) Representative: **ASML Netherlands B.V.**
**Corporate Intellectual Property**
**P.O. Box 324**
**5500 AH Veldhoven (NL)**

Remarks:
Claims 16- 26 are deemed to be abandoned due to
non-payment of the claims fees (Rule 45(3) EPC).

(54) **SAFETY MECHANISM FOR PATTERNING DEVICE**

(57) A safety mechanism for a patterning device of a lithographic apparatus, the safety mechanism comprising: a support structure configured to secure the patterning device on a support region of the support structure; and a plurality of magnetic elements located outwardly of the support region, wherein the magnetic elements are arranged such that magnetic force between the magnetic elements and complementary magnetic members fixed relative to the patterning device exerts a force on the patterning device towards the support structure.

Fig. 3

EP 4 776 066 A1

**Description**

FIELD

The present invention relates to a safety mechanism for a patterning device a method for providing a safety mechanism for a patterning device, a method for loading a patterning device and a method for unloading a patterning device.

BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., comprising part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

Lithography is widely recognized as one of the key steps in the manufacture of ICs and other devices and/or structures. However, as the dimensions of features made using lithography become smaller, lithography is becoming a more critical factor for enabling miniature IC or other devices and/or structures to be manufactured.

A theoretical estimate of the limits of pattern printing can be given by the Rayleigh criterion for resolution as shown in equation (1):

$$CD = k_1 * \frac{\lambda}{NA} \qquad (1)$$

where $\lambda$ is the wavelength of the radiation used, NA is the numerical aperture of the projection system used to print the pattern, k1 is a process-dependent adjustment factor, also called the Rayleigh constant, and CD is the feature size (or critical dimension) of the printed feature. It follows from Equation (1) that reduction of the minimum printable size of features can be obtained in three ways: by shortening the exposure wavelength $\lambda$, by increasing the numerical aperture NA or by decreasing the value of k1.

In order to shorten the exposure wavelength and, thus, reduce the minimum printable size, it has been proposed to use an extreme ultraviolet (EUV) radiation source. EUV radiation is electromagnetic radiation having a wavelength within the range of 10-20 nm, for example within the range of 13-14 nm. It has further been proposed that EUV radiation with a wavelength of less than 10 nm could be used, for example within the range of 5-10 nm such as 6.7 nm or 6.8 nm. Such radiation is termed extreme ultraviolet radiation or soft x-ray radiation. Possible sources include, for example, laser-produced plasma sources, discharge plasma sources, or sources based on synchrotron radiation provided by an electron storage ring.

Once the EUV radiation has been generated, it is directed through the lithographic apparatus by a plurality of mirrors to a component such as a patterning surface of a patterning device, which imparts the desired pattern to the EUV radiation.

The patterning device may be supported by a support structure. The patterning device may be clamped onto the support structure, for example by a vacuum clamping force and/or by an electrostatic force. The patterning device may be supported in such a way that if the clamping force fails, then the patterning device would move off the support structure. For example, the patterning device may fall under gravity. This can undesirably cause damage to the patterning device and/or other components of the lithographic apparatus. Particles may also undesirably be generated. Such particles are a defectivity risk.

It is possible to provide the lithographic apparatus with safety catches to catch the patterning device if it should fall from the support structure for any reason. These catchers require active electronics and motors and sensors.

It is desirable to reduce one or more of the cost, mass and design complexity of the lithographic apparatus, without unduly increasing the risk of damage and/or particle creation.

SUMMARY OF THE INVENTION

An aim of the present invention is to reduce one or more of the cost, mass and design complexity of the lithographic apparatus, without unduly increasing the risk of damage and/or particle creation.

According to the present invention, there is provided a safety mechanism for a patterning device of a lithographic apparatus, the safety mechanism comprising:

a support structure configured to secure the patterning device on a support region of the support structure; and
a plurality of magnetic elements located outwardly of the support region, wherein the magnetic elements are arranged such that magnetic force between the magnetic elements and complementary magnetic members fixed relative to the patterning device exerts a force on the patterning device towards the support structure.

Also according to the present invention, there is provided a method for providing a safety mechanism for a patterning device of a lithographic apparatus, the method comprising:

securing the patterning device on a support region of a support structure; and
locating a plurality of magnetic elements outwardly of the support region, wherein the magnetic elements are arranged such that magnetic force between the magnetic elements and complementary magnetic members fixed relative to the patterning device exerts a force on the patterning device towards the support structure.

BRIEF DESCRIPTION OF THE DRAWINGS

Embodiments of the invention will now be described, by way of example only, with reference to the accompanying schematic drawings, in which corresponding reference symbols indicate corresponding parts.

Figure 1 schematically depicts a lithographic apparatus.
Figure 2 schematically depicts a more detailed view of the lithographic apparatus.
Figure 3 schematically depicts a cross-sectional view of a safety mechanism.
Figure 4 schematically depicts a plan view of the safety mechanism shown in Figure 3.
Figure 5 schematically depicts an alternative safety mechanism.
Figure 6 schematically depicts an alternative safety mechanism.
Figure 7 schematically depicts an alternative safety mechanism.
Figure 8 schematically depicts an arrangement of magnets for the safety mechanism shown in Figure 6, for example.

The features shown in the Figures are not necessarily to scale, and the size and/or arrangement depicted is not limiting. It will be understood that the Figures include optional features which may not be essential to the invention. Furthermore, not all of the features of the apparatus are depicted in each of the Figures, and the Figures may only show some of the components relevant for describing a particular feature.

DETAILED DESCRIPTION

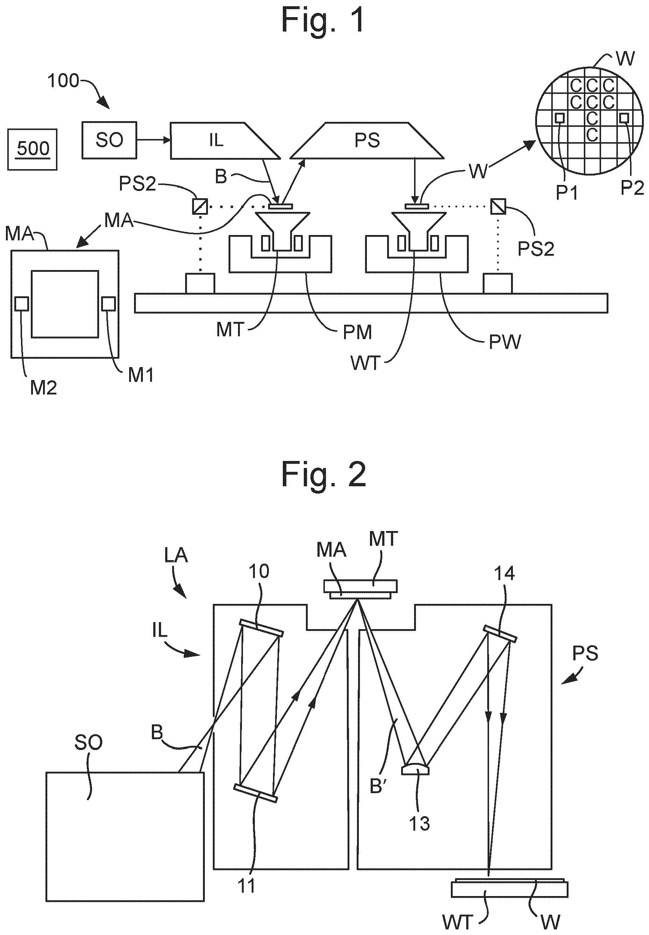

Figure 1 schematically depicts a lithographic apparatus 100 including a radiation source SO according to one embodiment of the invention. The apparatus 100 comprises:

-    an illumination system (or illuminator) IL configured to condition a radiation beam B (e.g., EUV radiation).
-    a support structure (e.g., a mask table) MT constructed to support a patterning device (e.g., a mask or a reticle) MA and connected to a first positioner PM configured to accurately position the patterning device;
-    a substrate table (e.g., a wafer table) WT constructed to hold a substrate (e.g., a resist-coated wafer) W and connected to a second positioner PW configured to accurately position the substrate; and
-    a projection system (e.g., a reflective projection system) PS configured to project a pattern imparted to the radiation beam B by patterning device MA onto a target portion C (e.g., comprising one or more dies) of the substrate W.

The illumination system IL may include various types of optical components, such as refractive, reflective, magnetic, electromagnetic, electrostatic or other types of optical components, or any combination thereof, for directing, shaping, or controlling radiation.

The support structure MT holds the patterning device MA in a manner that depends on the orientation of the patterning device, the design of the lithographic apparatus, and other conditions, such as for example whether or not the patterning device is held in a vacuum environment. The support structure MT can use mechanical, vacuum, electrostatic or other clamping techniques to hold the patterning device MA. The support structure MT may be a frame or a table, for example, which may be fixed or movable as required. The support structure MT may ensure that the patterning device MA is at a desired position, for example with respect to the projection system PS.

The term "patterning device" should be broadly interpreted as referring to any device that can be used to impart a radiation beam B with a pattern in its cross-section such as to create a pattern in a target portion C of the substrate W. The pattern imparted to the radiation beam B may correspond to a particular functional layer in a device being created in the target portion C, such as an integrated circuit.

Examples of patterning devices include masks, programmable mirror arrays, and programmable liquid-crystal display (LCD) panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

The projection system PS, like the illumination system IL, may include various types of optical components, such as refractive, reflective, magnetic, electromagnetic, electrostatic or other types of optical components, or any combination thereof, as appropriate for the exposure radiation being used, or for other factors such as the use of a vacuum. It may be desired to use a vacuum for EUV radiation since other gases may absorb too much radiation. A vacuum environment may therefore be provided to the whole beam path with the aid of a vacuum wall and vacuum pumps.

As here depicted, the lithographic apparatus 100 is of a reflective type (e.g., employing a reflective mask).

The lithographic apparatus 100 may be of a type having two (dual stage) or more substrate tables WT (and/or two or more support structures MT). In such a "multiple stage" lithographic apparatus the additional substrate tables WT (and/or the additional support structures MT) may be used in parallel, or preparatory steps may be carried out on one or more substrate tables WT (and/or one or more support structures MT) while one or more other substrate tables WT (and/or one or more other support structures MT) are being used for exposure.

Referring to Figure 1, the illumination system IL receives an extreme ultraviolet radiation beam from the radiation source SO. The radiation source SO may be a laser produced plasma (LPP) source, a discharge produced plasma (DPP) source, a free electron laser (FEL) or any other radiation source that is capable of generating EUV radiation. Methods to produce EUV light include, but are not necessarily limited to, converting a material into a plasma state that has at least one element, e.g., xenon, lithium or tin, with one or more emission lines in the EUV range. In laser produced plasma ("LPP"), the required plasma can be produced by irradiating a fuel, such as a droplet, stream or cluster of material having the required line-emitting element, with a laser beam. The radiation source SO may be part of an EUV radiation system including a laser, not shown in Figure 1, for providing the laser beam exciting the fuel. The resulting plasma emits output radiation, e.g., EUV radiation, which is collected using a radiation collector, disposed in the radiation source SO. The laser and the radiation source SO may be separate entities, for example when a $CO_2$ laser is used to provide the laser beam for fuel excitation.

In such cases, the laser is not considered to form part of the lithographic apparatus 100 and the radiation beam B is passed from the laser to the radiation source SO with the aid of a beam delivery system comprising, for example, suitable directing mirrors and/or a beam expander. In other cases the source may be an integral part of the radiation source SO, for example when the source is a discharge produced plasma EUV generator, often termed as a DPP source.

The illumination system IL may comprise an adjuster for adjusting the angular intensity distribution of the radiation beam. Generally, at least the outer and/or inner radial extent (commonly referred to as σ-outer and σ-inner, respectively) of the intensity distribution in a pupil plane of the illumination system IL can be adjusted. In addition, the illumination system IL may comprise various other components, such as facetted field and pupil mirror devices. The illumination system IL may be used to condition the radiation beam B, to have a desired uniformity and intensity distribution in its cross-section.

The radiation beam B is incident on the patterning device (e.g., mask) MA, which is held on the support structure (e.g., mask table) MT, and is patterned by the patterning device MA. After being reflected from the patterning device (e.g., mask) MA, the radiation beam B passes through the projection system PS, which focuses the radiation beam B onto a target portion C of the substrate W. With the aid of the second positioner PW and position sensor PS2 (e.g., an interferometric device, linear encoder or capacitive sensor), the substrate table WT can be moved accurately, e.g., so as to position different target portions C in the path of the radiation beam B. Similarly, the first positioner PM and another position sensor PS1 can be used to accurately position the patterning device (e.g., mask) MA with respect to the path of the radiation beam B. The patterning device (e.g., mask) MA and the substrate W may be aligned using mask alignment marks M1, M2 and substrate alignment marks P1, P2.

A controller 500 controls the overall operations of the lithographic apparatus 100 and in particular performs an operation process described further below. Controller 500 can be embodied as a suitably-programmed general purpose computer comprising a central processing unit, volatile and non-volatile storage means, one or more input and output devices such as a keyboard and screen, one or more network connections and one or more interfaces to the various parts of the lithographic apparatus 100. It will be appreciated that a one-to-one relationship between controlling computer and lithographic apparatus 100 is not necessary. In an embodiment of the invention one computer can control multiple lithographic apparatuses 100. In an embodiment of the invention, multiple networked computers can be used to control one lithographic apparatus 100. The controller 500 may also be configured to control one or more associated process devices and substrate handling devices in a lithocell or cluster of which the lithographic apparatus 100 forms a part. The controller 500 can also be configured to be subordinate to a supervisory control system of a lithocell or cluster and/or an overall control system of a fab.

Figure 2 shows the lithographic apparatus 100 in more detail, including the radiation source SO, the illumination system IL, and the projection system PS. The radiation source SO is configured to generate an EUV radiation beam B and to supply the EUV radiation beam B to the lithographic apparatus LA. The lithographic apparatus LA comprises an illumination system IL, a support structure MT configured to support (e.g. secure) a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 80 and a facetted pupil mirror device 81. The faceted field mirror device 80 and faceted pupil mirror device 81 together provide the EUV radiation beam B with a desired cross-sectional shape and a desired intensity distribution. The illumination system IL may include other mirrors or devices in addition to, or instead of, the faceted field mirror device 80 and faceted pupil mirror device 81.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 83, 84 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 83, 84 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

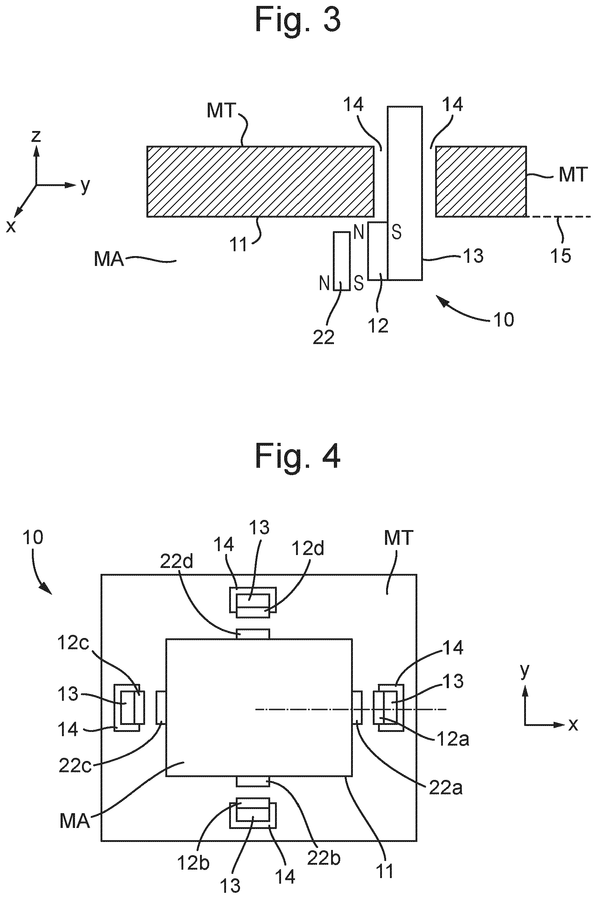

Figure 3 schematically depicts a safety mechanism 10. Figure 3 is a cross-sectional view of part of the safety mechanism 10. Figure 4 is a schematic plan view of the safety mechanism 10 shown in Figure 3. Figure 3 is a cross-sectional view taken along the dashed line shown in Figure 4.

In an embodiment the safety mechanism 10 is for a patterning device MA. The patterning device MA may be a patterning device MA of a lithographic apparatus. The safety mechanism 10 may be configured to increase safety of use of the patterning device MA.

As shown in Figure 3, in an embodiment the safety mechanism 10 comprises a support structure MT. The support structure is configured to support (e.g. secure) the patterning device MA. In an embodiment the support structure MT is configured to secure the patterning device MA on a support region 11 of the support structure MT. As shown in Figure 3, in an embodiment the support region 11 partly faces downwards. However, it is not essential for the support region 11 to face downwards. In an alternative arrangement, the support region 11 faces sideways, or faces upwards on an incline. The support region 11 forms part (but not all) of a major surface of the support structure MT. As shown in Figure 3, there may be part of the surface of the support structure MT that is beyond where the patterning device MA is supported. That is, part of the downwards facing surface of the support structure MT may extend radially (i.e. outwards in the X-Y plane from the centre of the support structure MT) beyond the patterning device MA.

In an embodiment the support region 11 comprises a plurality of burls. The burls protrude from a base surface of the support structure MT. The burls have distal ends arranged in a plane for supporting the patterning device MA. By providing the burls, the surface area of the support structure MT that comes into contact with the patterning device MA is reduced. By reducing the surface area, the flatness of the patterning device MA supported by the support structure MT may be increased.

In an embodiment the support structure MT is configured to clamp the patterning device MA onto the support structure by a clamping force. In an embodiment the clamping force is a vacuum clamping force. A volume among the burls between the support structure MT and the patterning device MA may be in fluid communication with an under pressure so as to provide the clamping force. Additionally or alternatively, the clamping force may be an electrostatic force. For example, the support structure MT may be provided with one or more electrodes. The electrodes may be connected to a power supply configured to control an electric potential of the one or more electrodes. The electrodes may generate an electric field configured to interact with the patterning device MA so as to clamp the patterning device MA to the support structure MT.

As shown in Figure 4, in an embodiment the safety mechanism 10 comprises a plurality of magnetic elements 12a, 12b, 12c, 12d. Figure 3 schematically depicts one of those magnetic elements 12. In the arrangement shown in Figure 4, four magnetic elements 12 are provided. However, it is not essential for there to be four magnetic elements 12. In an alternative embodiment, the safety mechanism 10 comprises two magnetic elements 12, three magnetic elements 12 or more than four magnetic elements 12. By increasing the number of magnetic elements 12, the stability of a force preventing uncontrolled movement of the patterning device MA away from the support structure MT may be increased. By reducing the number of magnetic elements 12, the volume and/or mass of the safety mechanism may be reduced.

As shown in Figure 4, in an embodiment the magnetic elements 12 are located outwardly of the support region 11. The magnetic elements 12 are outward of the patterning device when viewed in a direction perpendicular to the plane of the patterning device MA. In an embodiment the magnetic elements are located outward from the centre along the periphery of the support region 11. The support region 11 corresponds to the area in plan view taken up by the patterning device MA on the support structure MT. Here, plan view refers to a view in a direction substantially perpendicular to a plane of the patterning device and/or of the support structure MT. In the coordinate system used in the Figures, a plan view is a view along the Z direction. In the arrangements shown in the Figures, the Z direction is the vertical direction. However, as mentioned elsewhere, the patterning device MA may be differently oriented, in which case the Z direction shown in the Figures may be tilted away from the vertical direction.

The outward direction refers to a direction outwardly from the centre of the patterning device MA. In Figure 4, the four magnets 12a, 12b, 12c, 12d are located outwardly of the area taken up by the patterning device MA, i.e. the support region 11.

As shown in Figure 4, in an embodiment there are complementary magnetic members 22 fixed relative to the patterning device MA. Figure 4 schematically depicts four such complementary magnetic members 22a, 22b, 22c, 22d. The number of complementary magnetic members 22 is equal to the number of magnetic elements 12. Figure 3 shows one of the complementary magnetic members 22.

As shown in Figure 3, the complementary magnetic member 22 may be secured to an outward surface of the patterning device MA. The outward surface may face at least partly in a direction parallel to a plane of the patterning device MA. The complementary magnetic member 22 may be secured to the patterning device MA by an adhesive and/or by a fixing mechanism such as a screw, for example.

As shown in Figure 3, in an embodiment the complementary magnetic member 22 is secured directly to the patterning device MA. In an alternative embodiment, the complementary magnetic member 22 is fixed relative to the patterning device MA via an intermediate body. For example, in an embodiment the patterning device MA is provided with a pellicle for protecting a surface of the patterning device MA that patterns the radiation beam B. The pellicle may comprise a pellicle frame configured to cure the frame of the pellicle to the patterning device MA. In an embodiment the complimentary magnetic member 22 is secured to the pellicle frame so as to fix the position of the complementary magnetic member 22 relative to the patterning device MA.

In an embodiment the magnetic members 12 are arranged such that magnetic force between the magnetic elements 12 and the complementary magnetic members 22 exerts a force on (i.e. urges) the patterning device MA towards the support structure MT. By providing the magnetic force exerting a force on the patterning device MA towards the support structure MT, the possibility of uncontrolled movement of the patterning device MA away from the support structure MT is reduced. An embodiment of the invention is expected to reduce the possibility of the patterning device MA falling down onto other components of the lithographic apparatus. For example, in an embodiment the patterning device may face downwards in the lithographic apparatus. The patterning device MA may be clamped from its backside with a high voltage, for example. In an embodiment the patterning device may be clamped substantially continuously to prevent it from falling. The safety mechanism 10 may be provided as an additional safety measure to catch the patterning device MA if it should fall from the support structure MT for any reason.

By providing that the magnetic elements 12 are located outward of the support region 11, necessary to physically move the magnetic elements 12 loading or unloading of a patterning device MA. The embodiment of the invention is expected to simplify procedures for loading and unloading patterning device MA. Allowing the magnetic elements 12 to remain in place during loading and unloading, the active electronics, motors and sensors that would be required in order to actuate the safety mechanism may be omitted. The embodiment of the invention is expected to reduce a volume of the environment of the patterning device MA. An embodiment of the invention is expected to reduce the cost of manufacturing the lithographic apparatus. An embodiment of the invention is expected to reduce the mass of the lithographic apparatus.

By reducing the possibility of uncontrolled movement of the patterning device MA away from the support structure MT, the possibility of particles being undesirably created is reduced. For example, the creation of glass and/or steel particles may be reduced. Such particles can be a defectivity risk. For example, any particles in the path of the radiation beam B or the patterned radiation beam B' may undesirably affect the pattern formed on the substrate W during an exposure operation. An embodiment of the invention is expected to reduce the defectivity risk both for the patterning device MA that becomes unclamped from the support structure MT and for other patterning devices MA used afterwards (by cross contamination via components of the lithographic apparatus such as masking blades).

If the patterning device MA comes loose from the support structure MT, then the magnetic force may exert a force on the patterning device MA towards the support structure MT such that the patterning device MA does not plop in an uncontrolled manner. If the known safety catches are used, then the safety catches can prevent the patterning device MA from dropping further by mechanically stopping the patterning device MA. However, the mechanical contact between the patterning device MA and the safety catches can result in particle generation. Furthermore, when a gas is provided between the patterning device MA and the support structure MT, then the gas pressure can increase the speed of movement of the patterning device MA away from the support structure MT in the event that the patterning device MA comes loose from the support structure MT. The magnetic force associated with the magnetic elements 12 helps to catch the patterning device MA without requiring significant mechanical contact. An embodiment of the invention is expected to reduce particle generation.

In an embodiment the magnetic elements are passive dipole magnets. In an embodiment the respective complementary magnetic members 22 are passive dipole magnets. The magnetic elements 12 and the complementary magnetic members 22 prevent the patterning device MA from falling down in between the surrounding magnetic elements 12. The magnetic elements 12 may be arranged on passive supports 13. As shown in Figure 4, in an embodiment the safety mechanism 10 comprises passive supports 13 to which the magnetic elements 12 are secured. The passive supports 13 may be referred to as safety catches. The complementary magnetic members 22 are attached to the patterning device MA.

As shown in Figure 3, in an embodiment the passive supports 13 extend through respective apertures 14 of the support structure MT. For example, as shown in Figure 4 in an embodiment the support structure MT comprises a plurality of apertures 14 for accommodating respective passive supports 13. The passive supports 13 are passive in that they are not required to be actuated during use of the lithographic apparatus. For example, the passive supports 13 may remain in place during clamping and unclamping of the patterning device MA relative to the support structure MT.

As shown in Figure 3, in an embodiment the passive supports 13 are longitudinal. The passive supports 13 may extend in the Z direction. By providing that the passive supports 13 extend through respective apertures 14 of the support structure MT, it is not necessary for the supports 13 to be secured to the support structure MT. for example, the support structures 13 may be secured to a frame of the lithographic apparatus. By mechanically supporting the passive supports 13 independently of the support structure MT, the possibility of the passive supports 13 undesirably deforming (i.e. changing the shape of) the support structure MT is reduced.

However, it is not essential for the passive supports 13 to extend through respective apertures 14 in the support structure MT. In an alternative arrangement, the passive supports 13 are secured (for example fixed) to the support structure MT. In a further alternative embodiment, the passive supports 13 may be omitted. For example, the magnets 12 may be secured directly to the support structure MT without requiring the passive supports 13. An embodiment of the invention is expected to reduce the mass of the lithographic apparatus.

However, by providing passive supports, it is not necessary for the magnets 12 to be secured directly to the support structure MT. The possibility of the support structure MT being undesirably deformed as a result of having either the magnets 12 or the passive supports 13 secured to it may be reduced.

As shown in Figure 3, the magnetic force that exerts a force on the patterning device MA towards the support structure MT does not require the magnets 12 (or any part of the passive supports 13) to be below the patterning device MA. The magnetic force between the magnetic elements 12 and the complementary magnetic members 22 works when the magnets are to the side of the patterning device MA. In an embodiment the magnetic elements 12 are arranged so as to restrict sideways movement of the patterning device MA.

For example, in Figure 4 in an embodiment, magnetic elements 12 are arranged on opposite sides of the support region 11. For example, the magnetic element 12a is on the opposite side of the support region 11 from the magnetic element 12c. Similarly, the magnetic elements 12b, 12d are provided on opposite sides of the support region 11. By providing magnetic elements 12 with the support region 11 between them, the possibility of undesirable sideways movement of the patterning device MA as a result of the magnetic force is reduced.

As shown in Figure 4, in an embodiment magnetic elements 12 are arranged at three or four different sides of the support region 11. For example, in an embodiment the patterning device MA is substantially a quadrilateral, for example a rectangle such as a square. In an embodiment the magnetic elements 12a, 12b, 12c, 12d are located on each of the four sides of the support region 11, the support region 11 corresponding in shape to the patterning device MA. However, it is not essential for magnetic elements 12 to be arranged at four different sides of the support region 11. For example, in an alternative embodiment two magnetic elements 12a, 12c are provided on opposite sides only of the support region 11. For example, the other magnetic elements 12b, 12d shown in Figure 4 may be omitted.

As shown in Figure 3, in an embodiment at least one of the magnetic elements 12 and its complementary magnetic member 22 form an attractive pair for which the magnetic force between them is attractive. The arrangement shown in Figure 3 may be referred to as an attractive magnet configuration.

As shown in Figure 3, for the at least one attractive pair, the magnetic element 12 is closer than its complementary magnetic member 22 to a plane 15 comprising the support region 11. The plane 15 comprising the support region 11 corresponds to a location along the Z axis. In the arrangement shown in Figure 3, the Z axis refers to the vertical direction. Accordingly, in the arrangement shown in Figure 3 the complementary magnetic member 22 is below magnetic element 12. In an alternative arrangement, the magnetic element 12 may be provided at substantially the same level as the complementary magnetic member 22. That is, the magnetic element 12 and the complementary magnetic member 22 may be located substantially the same distance from the plane 15 that comprises the support region 11.

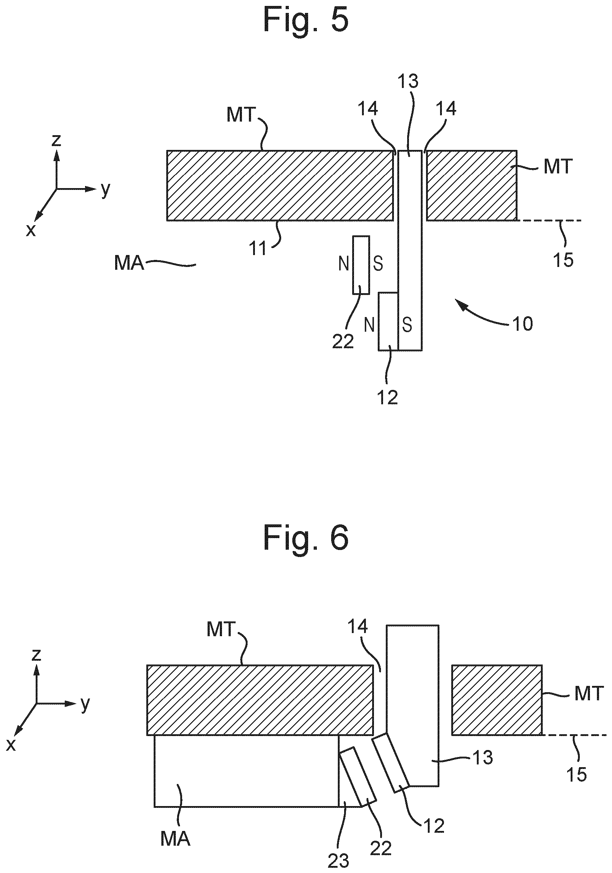

By providing that the complementary magnetic member 22 is at the same level or below the magnetic element 12, the possibility of the magnetic force undesirably pulling on the patterning device MA may be reduced. However, it is not essential for all pairs of magnetic elements 12 with their respective complementary magnetic members 22 to be attractive pairs. For example, as shown in Figure 5, at least one of the magnetic elements 12 and its respective complementary magnetic member 22 form a repulsive pair for which the magnetic force between them is repulsive. The configuration shown in Figure 5 may be referred to as a repulsive magnet configuration.

As shown in Figure 5, in an embodiment for the at least one repulsive pair, the magnetic element 12 may be further than its complementary magnetic member 22 from the plane 15 comprising the support region 11. In other words, the complementary magnetic member 22 is above the magnetic element 12 in the orientation shown in Figure 5. This may help to reduce the possibility that the magnetic force undesirably pushes the patterning device MA away from the support structure MT.

In an embodiment, all of the pairs of magnetic elements 12 with their respective complementary magnetic members 22 are attractive pairs. In an alternative embodiment, all of the pairs of magnetic elements 12 with their respective complementary magnetic members 22 are repulsive pairs. In an alternative embodiment, the pairs of magnetic members 12 with their respective complementary magnetic members 22 comprise at least one attractive pair and at least one repulsive pair. For example, in the arrangement shown in Figure 4, the magnetic elements 12a, 12c with their respective complementary magnetic members 22a, 22c may be attractive pairs. The magnetic elements 12b, 12d with their respective complementary magnetic members 22b, 22d may form repulsive pairs.

As shown in Figure 3 or Figure 5, for example, in an embodiment the cross-section of the magnetic elements 12 and the complementary magnetic members 22 is straight. That is, the major surfaces of the magnetic elements 12 and the complementary magnetic members 22 may face substantially sideways (i.e. horizontally). However, this is not essential. Figure 6 schematically depicts an alternative arrangement in which cross-section of the magnetic elements 12 and the complementary magnetic members 22 is skewed. The magnetic elements 12 may be arranged to have a major surface with a normal partly along a direction perpendicular to the support region 11 and towards the complementary magnetic member 22. By providing that the cross-section is skewed, less force may be generated in the X direction and/or the Y direction, with a greater magnetic force in the Z direction. The magnetic force in the Z direction desirably exerts a force on the patterning device MA towards the support structure MT. The arrangement shown in Figure 6 may desirably increase the efficiency of the safety mechanism by increasing the amount of the magnetic force that desirably exerts a force on the patterning device MA towards the support structure MT.

However, it is not essential for the magnetic elements 12 or the complementary magnetic members 22 to be skewed. As shown in Figure 3 and Figure 5, in an embodiment the magnetic elements 12 are substantially planar with poles at their major surfaces. For example, the magnetic elements 12 and/or the complementary magnetic members 22 may be disc magnets.

In an embodiment the magnetic elements 12 are arranged to have a major surface facing inwards towards the patterning device MA.

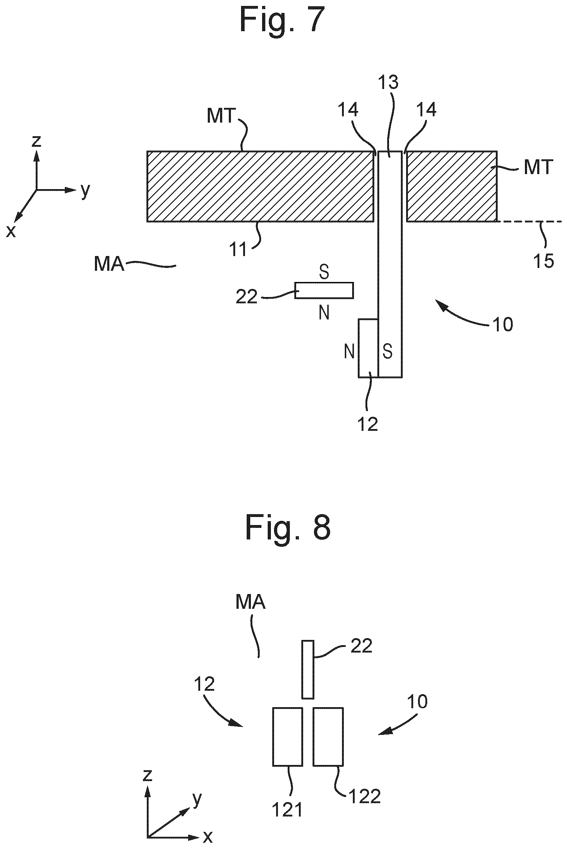

As shown in Figure 3, and Figure 5, for example, in an embodiment the complementary magnetic members 22 are located to the side of the patterning device MA. The side may be the outward peripheral edge of the patterning device MA. The side may be a minor surface of the patterning device MA. However, it is not essential for the complementary magnetic members 22 to be secured to the side surface of the patterning device MA. For example, as shown in Figure 7 in an embodiment the complementary magnetic members 22 are secured to the front side of the patterning device MA. The front side of the patterning device MA may be a major surface of the patterning device MA. The front side of the patterning device may be a surface of the patterning device MA configured to pattern the radiation beam B. For example, in an embodiment the complementary magnetic members 22 may be adhered or mechanically secured (e.g. by a screw or a clamp) to the front side of the patterning device MA.

In an embodiment, a subset of the complementary magnetic members 22 are secured to the side of the patterning device MA and another subset of the complementary magnetic members 22 are secured to the front side of the patterning device MA.

In an alternative embodiment the complementary magnetic members 22 are secured to the backside of the patterning device MA. The backside of the patterning device MA may be the side of the patterning device MA that faces towards the support structure MT. For example, in an embodiment the patterning device MA may be provided with one or more recesses for accommodating one or more respective complementary magnetic members 22. Providing the complementary magnetic members 22 in recesses on the backside of the patterning device MA, it may be easier to clean the front side of the patterning device MA.

In an embodiment the magnetic elements are disc magnets. In an embodiment the magnetic elements 12 have a lateral dimension (albeit oriented vertically in Figure 3, Figure 5 and Figure 7) of at least 1 mm, optionally at least 5 mm and optionally at least 10 mm. In an embodiment the magnetic elements 12 have a diameter of at most 20 mm, optionally at most 10 mm and optionally at most 5 mm. In an embodiment the magnetic elements 12 have a thickness of at least 0.2 mm, optionally at least 0.5 mm, optionally at least 1 mm and optionally at least 2 mm. In an embodiment the magnetic elements 12 have a thickness of at most 5 mm, optionally at most 2 mm and optionally at most 1 mm. By increasing the volume of the magnetic elements 12, the strength of the magnetic force may be increased. By reducing the volume of the magnetic elements 12, the space taken up by the magnetic elements 12 may be reduced. In an embodiment the complementary magnetic members 22 may be sized substantially similarly to the magnetic elements 12.

In an embodiment the safety mechanism 10 is configured to substantially prevent vertical movement of the patterning device MA. In an embodiment pairs of magnets on opposite sides of the patterning device MA can substantially reduce or prevent sideways movement. As shown in Figure 4, an additional pair of magnet pairs is provided in an orthogonal direction.

Figure 8 schematically depicts an alternative arrangement of magnets for the safety mechanism 10. Figure 8 schematically depicts one repulsive pair. As shown in Figure 8, for the at least one repulsive pair, one of the magnetic elements 12 and its complementary magnetic member 22 comprises two parts on either side of the other of the magnetic elements 12 and its complementary magnetic member 22 in a direction parallel to a plane of the patterning device MA.

For example, in the arrangement shown in Figure 8, the magnetic element 12 comprises two parts 121, 122. The two parts 121, 122 are on either side of the complementary magnetic member 22. In the orientation shown in Figure 8, the direction parallel to a plane of the patterning device MA corresponds to the X direction.

In an alternative arrangement, the complementary magnetic member 22 comprises two parts. The two parts of the complementary magnetic member may be on either side of the magnetic element 12.

In other words, an asymmetry is introduced into the repulsive pair. This can help to create a locking force in the X direction in Figure 8. Meanwhile, the presence of another repulsive pair on the opposite side of the patterning device MA may help to provide a locking force in the Y direction. Accordingly, a locking force may be provided in orthogonal directions in the X-Y plane.

As shown in Figure 8, one of the two magnets may be split in the vertical direction. The other may be centered in the middle of the split magnet. The arrangement shown in Figure 8, the complementary magnetic member 22 experiences a stronger repelling force if it moves away from the centre, pushing it back into the centre position.

Alternatively, a similar centering force may be provided by decentering the magnets within each pair. The magnetic elements 12 and respective complementary magnetic members 22 may be arranged such that the magnetic force opposes movement of the patterning device MA relative to the magnetic members 12 in directions parallel to the support region 11. For example, in the orientation shown in the Figures, the magnetic elements 12 and respective complementary magnetic members 22 may be arranged such that the magnetic force opposes movement of the patterning device MA relative to the magnetic members 12 in directions within the X-Y plane.

In an embodiment the patterning device MA is a substantially rigid body. By over determining the position of the patterning device MA with the pairs of magnets, the patterning device MA may be retained in substantially a stable position in the X-Y plane.

An embodiment of the invention is expected to reduce the requirement for maintenance of the lithographic apparatus. For example, the safety mechanism 10 uses a force that is passive and lasts forever. It is not necessary to perform periodic refreshing for maintenance of active electronics.

An embodiment of the invention is expected to reduce the possibility of undesirable damage to the lithographic apparatus. For example, the safety mechanism 10 uses a magnetic force that may result in iron or nickel based particles being attracted away from the critical image area (i.e. the area adjacent to the front side of the patterning device). The magnetic force of the safety mechanism 10 does not interfere with electrostatic clamping or with the use of hydrogen plasma or patterning radiation during exposures. The magnetic force of the safety mechanism 10 does not induce any risks of undesirable electrical discharges.

In an embodiment the magnetic elements 12 are permanent magnets. In an embodiment the complementary magnetic members 22 are permanent magnets. However, it is not essential for the magnetic elements 12 to be permanent magnets. For example, in an alternative embodiment one or more of the magnetic elements 12 is an electromagnet.

In an embodiment the safety mechanism 10 comprises at least one electromagnet adjacent a corresponding magnetic element 12. The electromagnets may be configured to selectively at least partly counteract the magnetic force associated with the magnetic elements 12. In an embodiment a controller (e.g. of the lithographic apparatus) may be configured to control the electromagnet so as to switch on or switch off the counteraction of the electromagnet to the magnetic force. When the electromagnet is activated, the electromagnet counters the magnetic field of the permanent magnetic element 12. When the electromagnet is deactivated, the magnetic field of the permanent magnetic element 12 is not counted.

An embodiment of the invention is expected to make loading and/or unloading of the patterning device MA easier. For example, during loading or unloading of the patterning device MA, the electromagnet may be switched on so as to reduce the magnetic force that could otherwise hamper the loading or unloading procedure. After loading of a patterning device MA onto the support structure MT, the electromagnet may be switched off such that the magnetic force associated with the magnetic element 12 acts to exert a force on the patterning device MA towards the support structure MT.

In an embodiment the magnetic element 12 comprise at least one of samarium, neodymium and iron nitride.

However, other types of magnetic material may be used.

In an embodiment at least one of the magnetic elements 12 comprises a coating. The coating is configured to protect the magnetic element 12 from hydrogen. For example, a magnetic element 12 that comprises neodymium may be provided with a coating so as to protect the neodymium from hydrogen. By providing the coating, the possibility of the magnetic element 12 becoming undesirably brittle as a result of reaction with the hydrogen is reduced. An embodiment of the invention is expected to increase the lifetime of the safety mechanism 10.

A lithographic apparatus in accordance with the present invention may be used for the manufacture of ICs.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Where the context allows, embodiments of the invention may be implemented in hardware, firmware, software, or any combination thereof. Embodiments of the invention may also be implemented by instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Although specific reference may have been made above to the use of embodiments of the invention in the context of optical lithography, it will be appreciated that the invention, where the context allows, is not limited to optical lithography.

**Claims**

1. A safety mechanism for a patterning device of a lithographic apparatus, the safety mechanism comprising:

   a support structure configured to secure the patterning device on a support region of the support structure; and
   a plurality of magnetic elements located outwardly of the support region, wherein the magnetic elements are arranged such that magnetic force between the magnetic elements and complementary magnetic members fixed relative to the patterning device exerts a force on the patterning device towards the support structure.

2. The safety mechanism of claim 1 comprising:
   passive supports to which the magnetic elements are secured.

3. The safety mechanism of claim 2, wherein the passive supports are fixed relative to a frame of the lithographic apparatus.

4. The safety mechanism of any preceding claim, wherein magnetic elements are arranged on opposite sides of the support region.

5. The safety mechanism of any preceding claim, wherein magnetic elements are arranged at at least three different sides of the support region.

6. The safety mechanism of any preceding claim, wherein at least one of the magnetic elements and its complementary magnetic member form an attractive pair for which the magnetic force between them is attractive.

7. The safety mechanism of claim 6, wherein for the at least one attractive pair, the magnetic element is closer than its complementary magnetic member to a plane comprising the support region.

8. The safety mechanism of any preceding claim, wherein at least one of the magnetic elements and its respective complementary magnetic member form a repulsive pair for which the magnetic force between them is repulsive.

9. The safety mechanism of claim 8, wherein for the at least one repulsive pair, the magnetic element is further than its complementary magnetic member from a plane comprising the support region.

10. The safety mechanism of claim 8 or 9, wherein for the at least one repulsive pair, one of the magnetic element and its complementary magnetic member comprises two parts on either side of the other of the magnetic element and its complementary magnetic member in a direction parallel to a plane of the patterning device.

11. The safety mechanism of any of claims 8-10, wherein the magnetic elements and respective complementary magnetic members are arranged such that the magnetic force opposes movement of the patterning device relative to the magnetic members in directions parallel to the support region.

12. The safety mechanism of any preceding claim, wherein the magnetic elements are substantially planar with poles at their major surfaces.

13. The safety mechanism of claim 12, wherein the magnetic elements are arranged to have a major surface facing inwardly towards the patterning device.

14. The safety mechanism of claim 12 or 13, wherein the magnetic elements are arranged to have a major surface with a normal partly along a direction perpendicular to the support region and towards the complementary magnetic member.

15. The safety mechanism of any preceding claim, wherein the magnetic elements are permanent magnets.

16. The safety mechanism of any preceding claim comprising:
at least one electromagnet adjacent a corresponding magnetic element and configured to selectively at least partly counteract the magnetic force associated with the magnetic element.

17. The safety mechanism of any preceding claim, wherein the magnetic elements comprise at least one of samarium, neodymium and iron nitride.

18. The safety mechanism of any preceding claim, wherein the magnetic elements comprise a coating configured to protect from hydrogen.

19. The safety mechanism of any preceding claim comprising:

an electrostatic chuck comprising the support structure;
the patterning device; and
the complementary magnetic members secured to the patterning device.

20. The safety mechanism of claim 19, wherein at least one of the complementary magnetic members is secured to an outwardly facing surface of the patterning device.

21. The safety mechanism of claim 19 or 20, wherein at least one of the complementary magnetic members is secured to a surface of the patterning device facing away from the support structure.

22. A method for providing a safety mechanism for a patterning device of a lithographic apparatus, the method comprising:

securing the patterning device on a support region of a support structure; and
locating a plurality of magnetic elements outwardly of the support region, wherein the magnetic elements are arranged such that magnetic force between the magnetic elements and complementary magnetic members fixed relative to the patterning device exerts a force on the patterning device towards the support structure.

23. A method for loading a patterning device, the method comprising:

the method of claim 22; and

loading the patterning device onto the support structure while the magnetic elements remain located at their locations at which the magnetic force exerts the force on the patterning device towards the support structure once the patterning device is loaded onto the support structure.

24. The method of claim 23, comprising:
temporarily activating at least one electromagnet adjacent a corresponding magnetic element to at least partly counteract the magnetic force associated with the magnetic element during the loading of the patterning device onto the support structure.

25. A method for unloading a patterning device, the method comprising:

the method of claim 22; and
unloading the patterning device from the support structure while the magnetic elements remain located at their locations at which the magnetic force exerted the force on the patterning device towards the support structure before the patterning device was unloaded.

26. The method of claim 25, comprising:
temporarily activating at least one electromagnet adjacent a corresponding magnetic element to at least partly counteract the magnetic force associated with the magnetic element during the unloading of the patterning device from the support structure.

# Fig. 1

# Fig. 2

# Fig. 3

# Fig. 4

# Fig. 5

# Fig. 6

# Fig. 7

# Fig. 8

## EUROPEAN SEARCH REPORT

**Application Number**

EP 25 15 0638

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 544 213 A (CHIBA YUJI [JP] ET AL) 6 August 1996 (1996-08-06) | 1-7, 12-15 | INV. G03F7/00 |
| A | * column 1, line 25 - column 2, line 14 * * figure 9 * ----- | 8-11 | |
| A | US 5 161 177 A (CHIBA YUJI [JP]) 3 November 1992 (1992-11-03) * the whole document * ----- | 1,8-11 | |

TECHNICAL FIELDS
SEARCHED     (IPC)

G03F

The present search report has been drawn up for all claims

| Place of search | Date of completion of the search | Examiner |
|---|---|---|
| Munich | 24 September 2025 | Meixner, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 0638

This annex lists the patent family members relating to the patent documents cited in the above-mentioned European search report.
The members are as contained in the European Patent Office EDP file on
The European Patent Office is in no way liable for these particulars which are merely given for the purpose of information.

24-09-2025

| Patent document cited in search report | | Publication date | Patent family member(s) | | Publication date |
|---|---|---|---|---|---|
| US  5544213 | A | 06-08-1996 | JP | 3244894 B2 | 07-01-2002 |
| | | | JP | H07153663 A | 16-06-1995 |
| | | | US | 5544213 A | 06-08-1996 |
| US  5161177 | A | 03-11-1992 | JP | H04162610 A | 08-06-1992 |
| | | | US | 5161177 A | 03-11-1992 |

EPO FORM P0459

For more details about this annex : see Official Journal of the European Patent Office, No. 12/82